# EUROPEAN PATENT APPLICATION

(11) **EP 2 887 776 A1**
(43) Date of publication of application: **24.06.2015**
(21) Application number: 13198187.0
(22) Date of filing: 18.12.2013
(51) Int. Cl.: H05K 1/02

(54) **A PCB with RF signal paths**

(71) Applicant: Advanced Digital Broadcast S.A., 1292 Chambesy (CH)
(72) Inventor: Grzelka, Piotr, 65-119 Zielona Gora (PL); Gizycki, Robert, 65-119 Zielona Gora (PL)
(74) Representative: Pawlowski, Adam

(57) **Abstract**

A printed circuit board (PCB) with radio frequency (RF) signal paths, comprising a first RF signal connector (141) connected to a first signal path (111) and a second RF connector (142) connected to a second signal path (121), wherein the PCB comprises at least three layers (110, 120, 130) and wherein the first signal path (111) is routed on the first layer (110), the second signal path (121) is routed on the second layer (120), and a third layer (130) between the first layer (110) and the second layer (130) has a ground plane (131) in an area (132) extending at least between the first signal path (111) and the second signal path (121).

## Description

The present invention relates to a printed circuit board (PCB) with RF signal paths.

The PCB can be used for example in a digital satellite television receiver receiving two satellite television signals or in a hybrid television receiver receiving e.g. a cable and terrestrial signal.

Some RF signal receivers are configured to receive two RF signals. For example, digital satellite television set-top boxes can be configured to receive two RF signals from two satellite television signal transponders, one signal to be used as a live watching signal and the other as an independent source for digital video recording (DVR) system. Such receivers may comprise an RF signal tuner with two inputs, capable of processing both RF signals.

When routing two RF signals over the PCB from signal inputs, such as an F-type connectors, to a tuner chip, the signals have to be shielded in order to avoid interference between them. Typically, these signals are routed on the same PCB layer on neighboring paths, which are separated by metal shields with a separate chamber for each signal. This requires the PCB to comprise structural holes for mounting the shield, as well as increases the complexity of mounting the shield, which typically needs to be done manually. The shield, being an external component to the PCB, increases its manufacturing cost.

The aim of the present invention is to provide an alternative configuration of a PCB with RF signal paths.

The object of the invention is a printed circuit board (PCB) with radio frequency (RF) signal paths, comprising a first RF signal connector connected to a first signal path and a second RF connector connected to a second signal path, wherein the PCB comprises at least three layers and wherein the first signal path is routed on the first layer, the second signal path is routed on the second layer, and a third layer between the first layer and the second layer has a ground plane in an area extending at least between the first signal path and the second signal path.

The first layer can be an external layer of the PCB or an internal layer of the PCB.

The second layer can be an external layer of the PCB or an internal layer of the PCB.

Preferably, the PCB further comprises an RF receiver having a first input pin with a contact pad on the first external layer to which the first signal path is connected and a second input pin with a contact pad to which the second signal path is connected through a second via.

Preferably, the second via connects the second signal path directly with the contact pad of the second input pin.

Preferably, the PCB further comprises a first via between the first signal path and the second external layer.

Preferably, the first via is a blind via.

Preferably, the impedance of the first signal path is equal to the impedance of the second signal path.

Preferably, the PCB comprises more than one internal layer between the first layer and the second layer.

The PCB with RF signal paths as presented in this description eliminates the need to use a separate RF shield with two chambers.

The PCB with RF signal paths is shown by means of exemplary embodiment on a drawing, in which:
Fig. 1 shows schematically a top view of the PCB;
Fig. 2 shows schematically a bottom view of the PCB;
Fig. 3 shows schematically a cross-section of the PCB.

The PCB 100 has at least three layers: a first external layer 110, a second external layer 120 and at least one middle layer 130. Two RF signal connectors 141, 142 are mounted at the edge of the PCB. The signal pin (called the hot wire) of the first connector 141 is connected, e.g. soldered, to a signal path 111 on the first external layer 110 and the signal pin of the second connector 142 is connected to a signal path 121 on the second external layer 120. The first signal path 111 routes the signal to a contact pad 151 of a first pin 152 of an RF signal receiver 150, such as an integrated circuit tuner, and is connected directly to the contact pad 151 on the same layer 110 of the PCB. The second signal path 121 routes the signal to a contact pad 153 of a second pin 154 of the integrated circuit tuner 150. The second signal path 121 is connected with the contact pad 153 of the second pin 154 through a second via 156. A ground plane 131 is provided at the middle layer 130 of the PCB in area 132, which covers at least the area between the RF signal paths 111, 121.

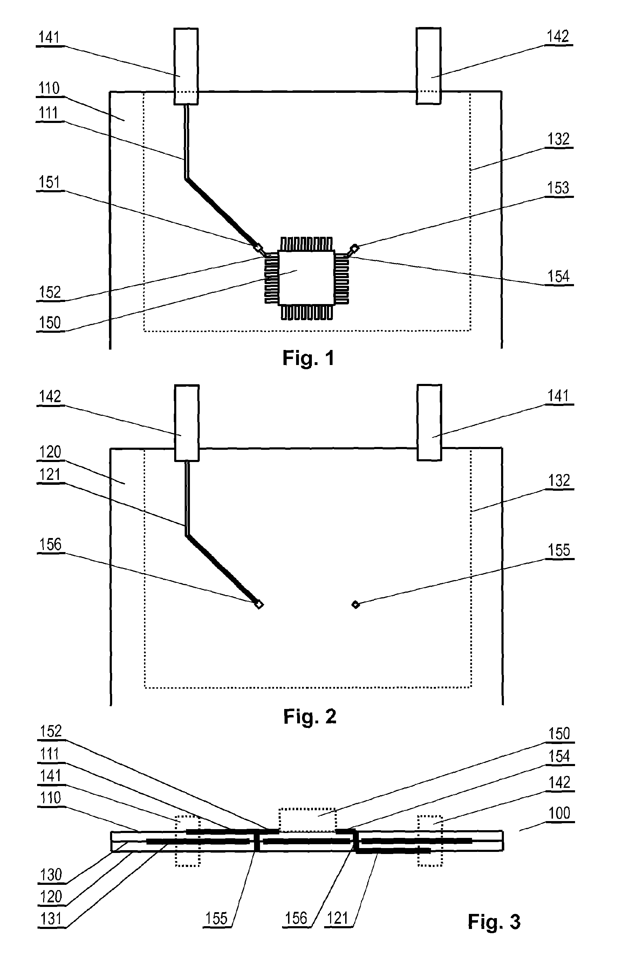

The shapes of the RF signal paths 111, 121 depends on the design of the particular RF receiver and the shapes shown in Fig. 1, 2 are exemplary only. The RF signal paths shall be preferably symmetrical to each other and have similar impedance.

In addition, a first via 155 can be connected to the contact pad 151 of the first pin 152, wherein the first via is preferably blind, i.e. its second end is not connected to any component on the second layer 120, and its function is to provide impedance of the first RF signal path to be equivalent to the impedance of the second RF signal path. The ground plane 131 has openings in areas corresponding to the vias 155, 156.

In the presented embodiment substantially whole RF signal paths 111, 121 are routed on external, opposite sides of the PCB, which guarantees most separation efficiency. Therefore, the second RF path 121 is preferably connected through the via 156 directly to the contact pad 153 of the RF signal receiver.

The PCB 100 may have more than one internal layer 130 with ground layers, which may improve shielding and may facilitate RF signal path matching.

In the presented embodiment, the RF signal paths are routed on external layers 110, 120 of the PCB. In alternative embodiment, at least one or both RF signal paths may be routed on internal layers of the PCB, provided that there is a grounding plane between the layers on which the RF signal paths are routed.

It will be understood by one skilled in the art that the presented embodiment can be further extended to other embodiments which will employ more than two RF signal inputs and corresponding signal paths, for example three, four or more inputs. It shall be understood that in such a case preferably all signal paths are routed on separate layers of the PCB, which are isolated from each other by a ground layer.

The drawings are not shown in scale, in particular the scale of the vertical direction of Fig. 3 is different than the scale of the horizontal direction, in order to better illustrate the concepts.

While the invention presented herein has been depicted, described, and has been defined with reference to particular preferred embodiments, such references and examples of implementation in the foregoing specification do not imply any limitation on the invention. It will, however, be evident that various modifications and changes may be made thereto without departing from the broader scope of the technical concept. The presented preferred embodiments are exemplary only, and are not exhaustive of the scope of the technical concept presented herein. Accordingly, the scope of protection is not limited to the preferred embodiments described in the specification, but is only limited by the claims that follow.

In addition, any combination of the appended claims in envisaged in the present application.

## Claims

1. A printed circuit board (PCB) with radio frequency (RF) signal paths, comprising a first RF signal connector (141) connected to a first signal path (111) and a second RF connector (142) connected to a second signal path (121), wherein the PCB comprises at least three layers (110, 120, 130) and wherein the first signal path (111) is routed on the first layer (110), the second signal path (121) is routed on the second layer (120), and a third layer (130) between the first layer (110) and the second layer (130) has a ground plane (131) in an area (132) extending at least between the first signal path (111) and the second signal path (121).

2. The PCB according to claim 1, wherein the first layer (110) is an external layer of the PCB.

3. The PCB according to claim 1, wherein the first layer (110) is an internal layer of the PCB.

4. The PCB according to claim 1, wherein the second layer (120) is an external layer of the PCB.

5. The PCB according to claim 1, wherein the second layer (120) is an internal layer of the PCB.

6. The PCB according to any of previous claims, further comprising an RF receiver (150) having a first input pin (151) with a contact pad (152) on the first external layer (110) to which the first signal path (111) is connected and a second input pin (153) with a contact pad (154) to which the second signal path (121) is connected through a second via (156).

7. The PCB according to claim 6, wherein the second via (156) connects the second signal path (121) directly with the contact pad (154) of the second input pin (153).

8. The PCB according to claim 6 or 7, further comprising a first via (155) between the first signal path (111) and the second external layer (120).

9. The PCB according to claim 8, wherein the first via (155) is a blind via.

10. The PCB according to any of previous claims, wherein the impedance of the first signal path (111) is equal to the impedance of the second signal path (121).

11. The PCB according to any of previous claims, comprising more than one internal layer (130) between the first layer (110) and the second layer (120).
